# EUROPEAN PATENT APPLICATION

(11) **EP 4 745 713 A1**
(43) Date of publication of application: **20.05.2026**
(21) Application number: 25203737.9
(22) Date of filing: 22.09.2025
(51) Int. Cl.: G06F 1/16, G02F 1/1333, H01R 13/627

(54) **COUPLING DEVICE AND FLAT PANEL DISPLAY HAVING THE SAME**

(30) Priority: 19.11.2024 KR 20240164771
(71) Applicant: Woo, Keon Woo, Hwaseong-si, Gyeonggi-do 18445 (KR)
(72) Inventor: Woo, Keon Woo, Hwaseong-si, Gyeonggi-do 18445 (KR)
(74) Representative: v. Bezold & Partner Patentanwälte - PartG mbB

(57) **Abstract**

The present invention discloses a coupling device for coupling two members and a flat display having the same. The coupling device of the present invention is composed of a fixture, a bracket, and a connector. The fixture has a coupling protrusion protruding from one surface, a pair of first snap fits formed on both sides of the coupling protrusion, a pair of second snap fits formed to be adjacent to each of the pair of first snap fits, and a third snap fit formed on opposite sides of the coupling protrusion. The bracket has a first locking hole formed to allow the coupling protrusion and each of the pair of first snap fits to be fitted and coupled, and a pair of second locking holes formed to allow the pair of second snap fits to be fitted and coupled. The connector has a locking hole formed to allow the third snap fit to be fitted and coupled. According to the present invention, the combination of the display module and the back cover can be easily automated by a simple structure in which the fixture of the combination device is combined with the combined bracket of the display module and then the back cover is combined with the fixture.

## Description

### Technical Field

The present invention relates to a technology for joining two members, and more specifically, to a joining device for joining two members, such as a display module and a back cover of a flat display, and a flat display having the same.

### Description of the Related Art

A flat panel display (FPD) is a display device with a thin, flat screen. Flat panel displays include liquid crystal displays (LCDs), organic light-emitting diodes (OLEDs), and light-emitting diode displays (LEDs), and are used in televisions, smartphones, tablet computers, and other devices. A flat panel display consists of a display module (i.e., an LCD panel), a circuit board, and a back cover. The circuit board is mounted on the back of the display module. The back cover is attached to the back of the display to cover the circuit board.

As an example of a flat display, the 'display device' disclosed in Korean Patent No. 10-2333558 includes a display module, a driving unit, and a back cover. A plurality of brackets are mounted on the back of a housing constituting the display module. A driving unit or driving board for driving the display module is mounted on the back of the housing. The back cover is connected to the bracket by a plurality of screws so as to cover the driving unit. The driving unit can be mounted inside the housing by connecting the housing and the back cover. However, the task of connecting the housing and the back cover by connecting the screws is difficult to automate.

Another example of a flat display is the "display device" disclosed in Korean Patent No. 10-2131663, which includes a display module, a circuit board, and a rear cover. The display module includes a top chassis and a bottom chassis. The circuit board is mounted on the rear of the bottom chassis. A plurality of hooks are formed on the rear edge of the top chassis. The hooks are connected to locking holes in the rear or back cover. However, because the hooks are formed integrally with the top chassis, the process of connecting the display module and the back cover is difficult to automate. The disclosures in the above patent documents are incorporated herein by reference.

Flat panel displays, as described above, are difficult to automate because they require the display module and back cover to be joined by screws or by the fitting of integrated hooks and locking holes. In particular, manually joining the display module and back cover requires significant labor, which reduces productivity and increases production costs. Therefore, there is a need for a joining device capable of automatically joining two components, such as the display module and back cover of a flat panel display.

The present invention aims to solve the various problems of flat-panel displays as described above. The purpose of the present invention is to provide a novel joining device capable of automatically joining two components, such as a display module and a back cover, using a simple joining device, and a flat-panel display equipped with the same.

Another purpose of the present invention is to provide a joining device capable of automatically joining two components, such as a display module and a back cover, thereby improving productivity and reducing production costs, and a flat-panel display equipped with the same.

### SUMMARY OF THE INVENTION

According to one aspect of the present invention, a coupling device is provided. The coupling device according to the present invention comprises a fixture, a bracket, and a connector. The fixture includes a coupling protrusion protruding from one surface, a pair of first snap fits formed on both sides of the coupling protrusion, a pair of second snap fits formed adjacent to each of the first snap fits, and a third snap fit formed on opposite sides of the coupling protrusion. The bracket includes a first locking hole formed to allow the coupling protrusion and each of the first snap fits to be engaged, and a pair of second locking holes formed to allow the pair of second snap fits to be engaged. Furthermore, the connector includes a locking hole formed to allow the third snap fit to be engaged.

According to another aspect of the present invention, a flat panel display includes a fixture, a display module having a bracket mounted on the rear surface, and a back cover equipped with a connector. The fixture is coupled to the bracket and the connector. The fixture includes a coupling protrusion protruding from one surface, a pair of first snap fits formed on either side of the coupling protrusion, a pair of second snap fits formed adjacent to each of the first snap fits, and a third snap fit formed on the opposite side of the coupling protrusion. The bracket includes a first locking hole formed to allow the coupling protrusion and each of the first snap fits to be engaged, and a pair of second locking holes formed to allow the pair of second snap fits to be engaged. The connector includes a locking hole formed to allow the third snap fit to be engaged.

The coupling device and flat panel display comprising the same according to the present invention have the advantage of facilitating automated coupling of the display module and the back cover through a simple structure in which the fixture of the coupling device is coupled to a bracket attached to the display module, and then the back cover is coupled to the fixture. Therefore, by automating the coupling of two components, such as the display module and the back cover, productivity can be improved and production costs can be reduced.

### BRIEF DESCRIPTION OF THE DRAWINGS

Figure 1 is a perspective view illustrating a flat display incorporating a coupling device according to the present invention.
Figure 2 is a perspective view illustrating a fixture of a coupling device according to the present invention.
Figure 3 is a front view illustrating a fixture of a coupling device according to the present invention.
Figure 4 is a cross-sectional view illustrating a flat display according to the present invention in a separated state.
Figure 5 is a cross-sectional view illustrating a flat display according to the present invention in a coupled state.

### DETAILED DESCRIPTION OF THE INVENTION

Other objects, specific advantages, and novel features of the present invention will become more apparent from the following detailed description and preferred embodiments, taken in conjunction with the accompanying drawings. In describing the present invention, the sizes and shapes of components depicted in the drawings may be exaggerated or simplified for clarity and convenience. Furthermore, terms specifically defined in consideration of the structure and operation of the present invention may be used differently depending on the inventor's intention or industry practice. These terms should be interpreted with meanings and concepts consistent with the technical purposes and uses of the present invention, based on the contents of this specification.

Hereinafter, preferred embodiments of a coupling device according to the present invention and a flat display including the same will be described in detail with reference to the attached drawings.

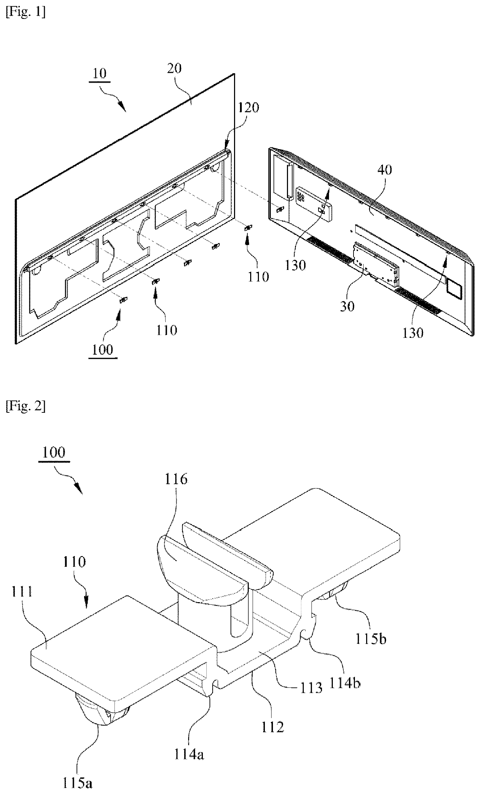

First, referring to FIG. 1, a flat display (10) according to the present invention includes a display module (20), a circuit board (30), and a back cover (40). The circuit board (30) is mounted on the front surface of the back cover (40). The back cover (40) is coupled to the back surface of the display module (20).

A coupling device (100) according to the present invention is used to couple two members, namely a display module (20) as a first member and a back cover (40) as a second member. The coupling device (100) according to the present invention includes a plurality of fixtures (110), a bracket (120), and a plurality of connectors (130).

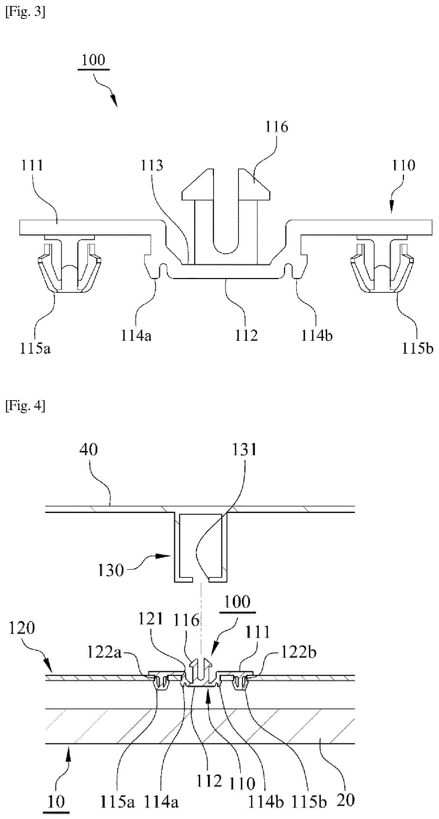

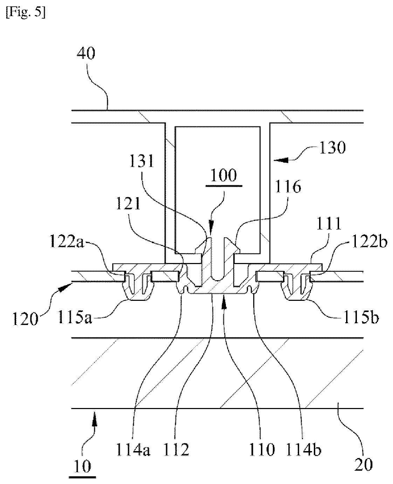

Referring to FIGS. 2 to 5, each fixture (110) includes a plate (111) and a coupling protrusion (112). The coupling protrusion (122) protrudes from the center of one side of the plate (111) and has a recess (113) formed on the opposite side. Each fixture (110) is composed of a pair of first snap fits (114a, 114b), a pair of second snap fits (115a, 115b), and a third snap fit (116).

As illustrated in FIGS. 1, 2, and 3, each of the first snap fits (114a, 114b) is formed on one side of the plate (111) so as to be positioned on either side of the engaging protrusion (112). Each of the second snap fits (115a, 115b) is formed on one side of the plate (111) so as to be positioned adjacent to each of the first snap fits (114a, 114b). The third snap fit (116) is formed on the bottom of the recess (113) so as to be positioned on the opposite side of the engaging protrusion

(112). As illustrated in FIGS. 1, 4, and 5, the bracket (120) is attached to the rear surface of the display module (20). The bracket (120) has a plurality of first locking holes (First locking holes: 121) and a pair of second locking holes (Second locking holes: 122a, 122b). Each of the first locking holes (121) is formed on the bracket (120) at a distance from each other so as to be able to engage the engaging protrusion (112) and the second snap fits (115a, 115b). Each of the second locking holes (122a, 122b) is formed on the bracket (120) so as to be able to engage the second snap fits (115a, 115b). Each of the second locking holes (122a, 122b) is arranged adjacent to both sides of each of the first locking holes (121). Each of the connectors (130) is formed on the back cover (40) at a distance from each other. The connector (130) is formed integrally with the back cover (40). The connector (130) has a locking hole (131) formed to allow the first snap fit (114a, 114b) to be coupled.

Now, the assembly process of a flat display using a coupling device according to the present invention having such a configuration will be described.

Referring to FIGS. 1, 4, and 5, the fixture (110) of the coupling device (100) is softened and used in the assembly process of the display module (20) and back cover (40) of the flat display (10). The fixture (110) is manufactured by injection molding using a rigid plastic, such as polyamide (PA). The rigid plastic fixture (110) can be softened by soaking it in water at approximately 90°C for approximately 50 minutes prior to the assembly process.

Meanwhile, the coupling protrusions (112) of the fixtures (110) are fitted into the respective first locking holes (121) of the bracket (120) and coupled, and the respective first snap fits (114a, 114b) are fitted into the respective first locking holes (121). The respective second snap fits (115a, 115b) of the fixtures (110) are fitted into the respective second locking holes (122a, 122b). At this time, since the fixtures (110) are in a softened state, the coupling protrusions (112), the first snap fits (114a, 114b) and the second snap fits (115a, 115b) can be easily fitted into the respective first and second locking holes (121, 122a, 122b). Additionally, the first snap fits (114a, 114b) and the second snap fits (115a, 115b) can be easily inserted into the first and second locking holes (121, 122a, 122b) respectively through elastic deformation. Therefore, the fixtures (110) can be automatically inserted into the display module (20) using automatic parts insertion equipment.

Subsequently, after each fixture (110) is inserted into the display module (20), the back cover (40) is inserted into the display module (20). By inserting the third snap fit (116) of each fixture (110) into the locking hole (131) of the connectors (130) through elastic deformation, the assembly process of the display module (20) and the back cover (40) can be easily completed. This simple structure, which allows fixtures (110) to be connected to the display module (20) using an automatic component inserter, improves productivity and reduces production costs.

The embodiments described above merely illustrate preferred embodiments of the present invention. The scope of the present invention is not limited to the described embodiments. Various modifications, variations, or substitutions may be made by those skilled in the art within the scope of the claims. It should be understood that such embodiments fall within the scope of the present invention.

## Claims

1. A coupling device comprising:
a fixture having a coupling protrusion protruding from one surface, a pair of first snap fits formed on both sides of the coupling protrusion, a pair of second snap fits formed adjacent to each of the pair of first snap fits, and a third snap fit formed on opposite sides of the coupling protrusion;
a bracket having a first locking hole formed to allow the coupling protrusion and each of the pair of first snap fits to be engaged, and a pair of second locking holes formed to allow the pair of second snap fits to be engaged;
a connector having a locking hole formed to allow the third snap fit to be engaged.

2. The coupling device of claim 1,
wherein a recess is formed on the opposite side of the coupling protrusion, and the third snap fit is formed at the bottom of the recess.

3. A flat panel display comprising:
a fixture having a protruding engaging protrusion on one side, a pair of first snap fits formed on both sides of the engaging protrusion, a pair of second snap fits formed adjacent to each of the first snap fits, and a third snap fit formed on opposite sides of the engaging protrusion;
a display module having a bracket mounted on the rear surface, the bracket having a first locking hole formed to allow the engaging protrusion and each of the first snap fits to be engaged, and a pair of second locking holes formed to allow the pair of second snap fits to be engaged;
a back cover equipped with a connector having a locking hole formed to allow the third snap fit to be engaged.
